# EUROPEAN PATENT SPECIFICATION

(11) **EP 3 958 660 B1**
(45) Date of publication and mention of the grant of the patent: **18.09.2024**
(21) Application number: 20192253.1
(22) Date of filing: 21.08.2020
(51) Int. Cl.: H05K 7/20

(54) **SUBSEA ELECTRONIC SHOCK-ABSORBING ASSEMBLY**
ELEKTRONISCHE SCHOCKABSORBIERENDE UNTERWASSERVORRICHTUNG
ENSEMBLE D'ABSORPTION DE CHOCS ÉLECTRONIQUE SOUS-MARIN

(43) Date of publication of application: 23.02.2022
(73) Proprietor: OneSubsea IP UK Limited, London EC4V 6JA (GB)
(72) Inventor: THIES, Reinhard, 29386 ALLERSEHL (DE); PHIELIPEIT-SPIESS, Volker, 29227 Celle, Nds. (DE)
(74) Representative: Schlumberger Intellectual Property Department

(56) References cited:
- US-A1- 2015 022 975
- US-A1- 2017 295 670
- US-A1- 2018 153 059
- US-A1- 2018 288 906

## Description

### BACKGROUND

Exploring, drilling and completing hydrocarbon and other wells are generally complicated, time consuming and ultimately very expensive endeavors. As a result, over the years, well architecture has become more sophisticated where appropriate in order to help enhance access to underground hydrocarbon reserves. For example, as opposed to land based oilfields accommodating wells of limited depth, it is not uncommon to find offshore oilfields with wells exceeding tens of thousands of feet in depth. Furthermore, today's hydrocarbon wells often include a host of lateral legs and fractures which stem from the main wellbore of the well toward a hydrocarbon reservoir in the formation.

In addition to the complexities of the field itself, ongoing management and periodic interventions may be particularly sophisticated undertakings. For example, it is not uncommon for a variety of different wells at a given field to require a variety of different applications and servicing at the same time and throughout production. This may include the simple opening and closing of different valves or a more rigorous undertaking such as the installation of monitoring equipment or the conducting of a cleanout application, just to name a few examples.

Given the amount of monitoring, management and interventions that may take place throughout the oilfield over time, subsea control modules (SCM's), housing any number of subsea electronic modules (SEM's), may be positioned at the seabed. The SEM's themselves may house electronics for interfacing with a variety of different application tools. In line with the examples above, the SEM and SCM package may be used to direct the opening or closing of different valves, obtain readings from different sensors for relay and use in guiding equipment installation or a cleanout. Of course, these tasks are merely exemplary and the package may be used to support countless other operations. Thus, the SEM itself may be similar to a sizeable mainframe computer or server accommodating a host of printed circuit boards (PCB's) and related electronics within the SCM.

Given the expense and importance of the SEM and SCM hardware, a variety of measures are undertaken to help assure safe and intelligent installation is achieved. For example, the outfitted SCM will generally be installed at larger hardware locations or platforms such as at a manifold or Christmas tree site. In this way, the SCM is afforded additional support rather than relying solely on its own frame for long-term structural support at the seabed. In addition to strategic placement for added support, the SEM design itself must undergo shock testing before being used in the field. Specifically, an industry standard API 17F rating is generally required before an SCM with SEM therein may be utilized at an oilfield. This includes directly subjecting the SEM to hours of random vibration testing and evaluating performance thereafter. Only where no detectable performance issues are presented will the model be qualified for use in the field.

Qualifying an SCM for field use as described above is understandable. Apart from the expense and the importance of the equipment, it is employed within a subsea oilfield environment. This means that it will be delivered to a seabed location potentially several thousand feet below surface and installed with heavy equipment where tight precision and delicacy are a challenge to maintain. Even after the likely natural blows of installation, ongoing operations present continued potential shocks and vibrations to the SCM and internal SEM, particularly in the case of gas production. Additionally, whether for an SCM directed activity or otherwise, interventions that includes various equipment being brought to the manifold or other SCM mounting site may be common, each with the potential to physically impact the assembly. Furthermore, the natural ebbs and flows of subsea currents present continual movement and vibration occurrences to the SCM/SEM.

Presently, measures to safeguard the SEM from the shock related realities of the environment include designing a structure in which printed circuit boards and other electronics are located within nitrogen filled compartments. A host of these compartments are assembled and encased for durability and shock-resistance. Unfortunately, many SEM designs also requires the use of several heat sinks which add weight to the unit rendering it more prone to fail the qualification process. In fact, even for an SEM qualified for use at the subsea oilfield, it is generally understood that the SEM is unlikely to withstand the rigors of the environment for the entirety of the life of the field.

US 2015/022975 A1 describes an electronic component cooling system including a dielectric fluid contained in a vessel, the vessel including a heat-conductive hull at least partially submerged in a heat sink fluid, where heat generated by an electronic component of the system is transferred into the dielectric fluid. US 2018/153059 A1 describes a marine subsea data vessel including a plurality of server boards coupled with a heat exchanger that operates to extract heat and transfer the heat to seawater entirely surrounding the marine subsea data vessel. US 2018/288906 A1 describes a cooling system for cooling of a heat generating electrical component having a coolant liquid to absorb excess energy from the heat generating electrical component, the coolant liquid having an energy input threshold above which chemical breakdown of the coolant liquid occurs. US 2017/295670 A1 describes an immersion cooled electronics arrangement includes a sealed housing, a coolant contained within the sealed housing, and an electronic device disposed within the sealed housing. The sealed housing has a variable-volume alterable between at least a first volume and a second volume in response to changes in pressure within the sealed chamber to reduce the rate of pressure change in the sealed housing over time form heating of the coolant.

### SUMMARY

The present invention resides in a subsea electronic assembly for positioning in an oilfield environment as defined in claim 1 and a method of managing operations at an oilfield as defined in claim 11. Preferred embodiments are defined in the dependent claims.

### BRIEF DESCRIPTION OF THE DRAWINGS

Fig. 1 is a front view of an embodiment of a subsea electronic assembly in the form of an SEM that houses both an electronic component in the form of PCB and a shock absorbing liquid.
Fig. 2A is an enlarged partial top view of a PCB of the assembly of Fig. 1 disposed within the shock absorbing liquid.
Fig. 2B is a side cross-sectional view of the PCB of Fig. 2A illustrating circulation of the liquid.
Fig. 3 is a perspective overview of a subsea oilfield with an SCM accommodating the SEM of Fig. 1 at a secure subsea hardware location with subsea.
Fig. 4A is a chart illustrating results of a random vibration test applied to the SEM of Fig. 1.
Fig. 4B is a chart illustrating results of a random vibration test applied to the SEM of Fig. 1 in a prior art comparison without the shock absorbing liquid.
Fig. 5 is a flow-chart summarizing an embodiment of employing a subsea electronic assembly in a subsea oilfield environment utilizing a housing with shock absorbing liquid about electronic components.

### DETAILED DESCRIPTION

In the following description, numerous details are set forth to provide an understanding of the present disclosure. However, it will be understood by those skilled in the art that the embodiments described may be practiced without these particular details. Further, numerous variations or modifications may be employed which remain contemplated by the embodiments as specifically described.

Embodiments are described with reference to certain subsea operations. For example, operations in which a cluster of wells at a seabed are each fluidly coupled to manifolds is described. In the embodiment shown, equipment cooperation is guided by an SCM which accommodates one or more SEM's and other features directed at helping to electronically facilitate operations where possible. However, a variety of different layouts may take advantage of the concepts detailed herein. For example, a variety of different electronic components for use with a host of different types of equipment and functions may take advantage of the architecture and techniques described. These may be referred to generally as electronic assemblies or modules, though the specific illustrative example of an SEM within an SCM is detailed herein. Indeed, so long as a unique configuration of a housing containing an electronic component with shock absorbing liquid is utilized in a subsea environment, appreciable benefit may be realized.

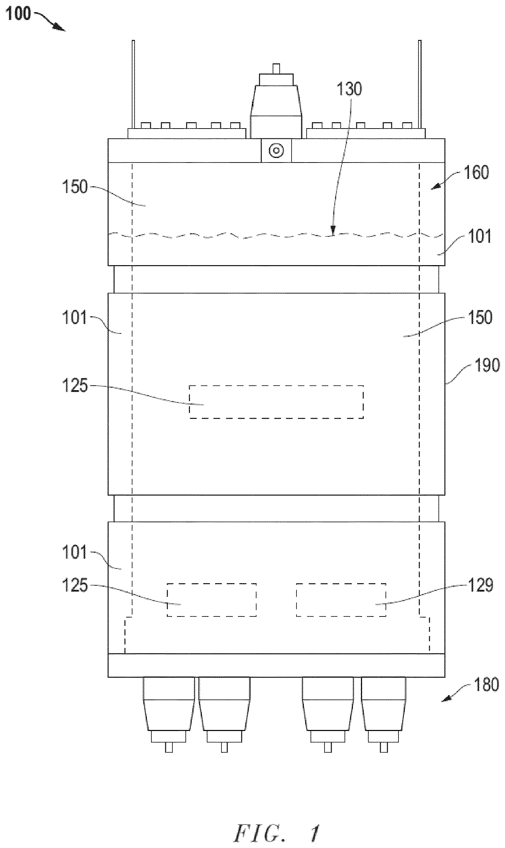

Referring now to Fig. 1, a front view of an embodiment of a subsea electronic assembly is shown in the form of an SEM 100. However, in other embodiments, the assembly may be an electronic actuator, a subsea sensor, a remote operated vehicle (ROV), an autonomous underwater vehicle (AUV) or a variety of other electrical tools or even communications equipment. Regardless, the illustrated SEM 100 houses a variety of electronic components such as multi-chip modules or the PCB's 125, 127 shown. Once more, the SEM 100 includes an outer housing 190 which may be of aluminum or other suitable material for the environment that is substantially filled with a shock-absorbing liquid 101. That is, the internal support structure 150 along with the accommodated PCB's 125, 127, 129 and other SEM features may take up a good portion of the area within the outer housing 190. Of the remaining space, for the embodiment shown, most is filled with the noted liquid 101 while the remainder constitutes a circulation space 160 with air or an inert gas such as nitrogen. More specifically, in the embodiment shown, the fill level 130 is in excess of about 75% the noted remaining space with the rest constituting the circulation space 160. As detailed below, the circulation space 160 may allow for a boiling of the shock-absorbing liquid, condensation thereof and eventual recirculation.

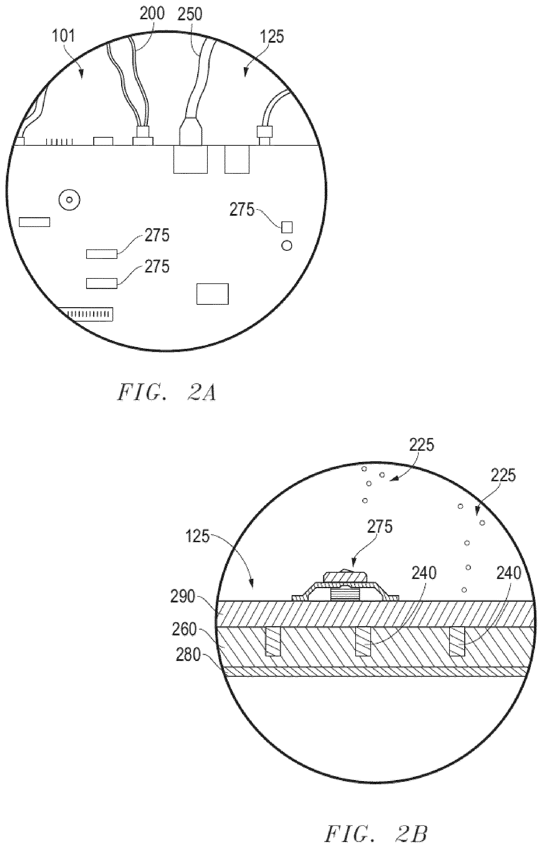

In the example embodiment noted above, the entirety of the SEM 100 interior of the housing 190 is made up of either structural hardware that includes the PCB's 125, 127, 129 (and other electronic and non-electronic features) or the noted circulation space 160. It is suggested that the circulation space may be less than about 25% of the remaining space that does not include the structural hardware. Of course, in other embodiments, the circulation space may be much less or even much greater. Furthermore, in one embodiment, shock and heat resistance for the SEM 100, which are facilitated by the shock-resistant liquid 101, are notably enhanced so long as the fill level 130 is above the height of the PCB's 125, 127, 129 and/or a majority of the electronic components of the SEM 100. Thus, the size of the circulation space 160 in terms of percentage volume of the "remaining space" may fluctuate greatly depending on the architectural layout of the SEM 100. So long as sufficient circulation space 160 is provided to allow for circulation as illustrated in Fig. 2B is provided, appreciable benefit from the use of the shock-absorbing liquid 101 may be realized.

As detailed further below, the shock-absorbing liquid 101 is selected to dampen shock and vibration that may be inherent in the installation of the SEM 100, production and other oilfield environment variables or even the effect of periodic interventions. The dampening of any vibrations inherent in the subsea environment may be of benefit to the long term performance of the SEM 100. Further, the liquid 101 should be of a dielectric variety given the prominent presence of electronics within the SEM 100.

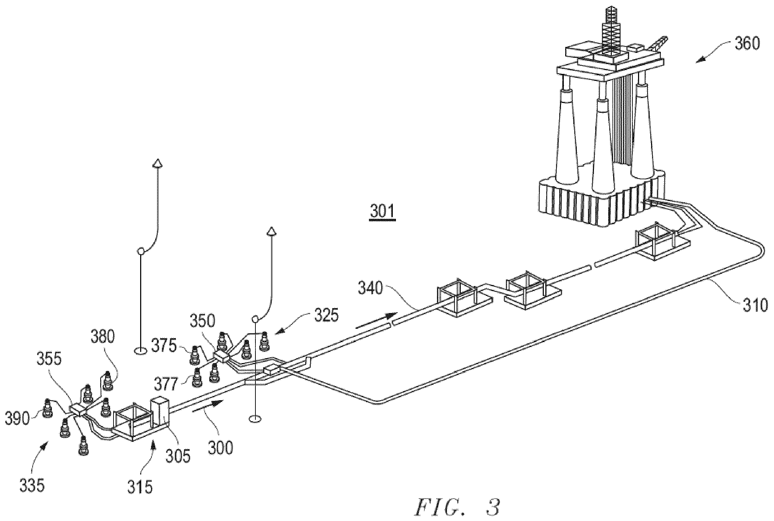

Continuing with reference to Fig. 1, other features of the SEM 100 are illustrated given the subsea environment in which it is to be utilized. For example, with added reference to Fig. 3, an SCM 305 which securely accommodates the SEM 100 at couplings 180 may be positioned at a seabed platform 315. These couplings 180 may help ensure the SEM 100 remains in place and also provide a route for supplying communications and/or power to the SEM 100 even from an external location even beyond the SCM 305. Regardless, as detailed further below, subsea operations facilitated through communications with the SEM 100 may be reliably ensured over a longer period due to the unique shock-resistance of the SEM 100 as detailed herein.

Referring now to Fig. 2A, an enlarged partial top view of a PCB 125 of the SEM 100 of Fig. 1 is shown disposed within the shock absorbing liquid 101. In the embodiment shown, the PCB 125 is outfitted with different electronic communications 200 and power supply 250 lines. As noted above, the prominence of the liquid 101 in the area of the PCB 125 and various electronic components may be of benefit to the PCB 125 in terms of shock absorbance. However, the presence of electronics means that the liquid 101 is a dielectric fluid. That is, just as dielectric materials are found within the PCB 125 itself, to help isolate conductive lines and other PCB electronic features, a similar dielectric fluid about the PCB 125 may similarly be of benefit. Liquid fluorinated ketones and fluorocarbons, such as commercially available 3M products, Novec^{®} and Fluorinert^{®}, respectively are good choices, although other dielectric fluids may be employed as well.

In addition to the shock absorbing nature of the liquid 101, as well as the electrical compatibility with the PCB 125, utilizing a dielectric form of the liquid may also provide additional benefits. For example, in addition to communications 200 and power 250 lines, the PCB 125 also includes a fair amount of other components 275 that tend to generate heat. These may include transistors, resistors, capacitors and a host of other conventional PCB features. Generally, managing this generated heat involves the use of heat sinks throughout the PCB 125. However, where the shock-absorbing liquid 101 is a compatible dielectric liquid, heat may be absorbed and circulated away from the PCB 125 in a manner that minimizes or even eliminates the use of such heat sinks. Indeed, with the liquid 101 in direct contact with the entire exposed surface area of the PCB 125, it may serve as a more effective heat dissipator than employing conventional heat sinks.

The effect of the shock-absorbing liquid 101 in substantially eliminating potentially damaging hot spots provides another advantage. That is, the reduction or elimination of heavy heat sinks changes the layout of the PCB 125 and may lead to a more compact designed subsea electronic assembly. This, in turn, may reduce installation costs with smaller ROV's or smaller installation delivery vessels being utilized. More specifically, the PCB 125 layout will be a lighter configuration. Thus, the PCB 125 may be even further resistant to shock induced damage. In other words, the introduction of the liquid 101 not only directly protects the PCB 125 but may also allow for a naturally more shock resistant PCB 125 configuration. Once more, this will also allow for the development of a more compact PCB 125 that does not need to account for as many heat sink locations. Thus, a higher performance may be expected from the same size PCB 125.

Similar to the substantial elimination of heat sinks, the PCB 125 may also forego the use of conventional conformal coatings that are often utilized to seal over the exposed surface of the PCB 125. Thus, the PCB 125 may advantageously be further lightened. Further, even without such a coating, the liquid 101 may also serve to help avoid dewing and corrosion at the surface of the PCB 125.

Referring now Fig. 2B, a side cross-sectional view of the PCB 125 of Fig. 2A is illustrated in a manner revealing a circulation of the shock-absorbing liquid 101. More specifically, notice the upward movement of bubbles 225 away from the top surface of the PCB 125. This is indicative of a degree of boiling of the liquid 101 in direct contact with the PCB 125. Thus, it is also indicative of the cooling of the PCB 125. That is, heat is being carried away from the PCB 125 by the liquid 101 which is illustrated in the bubbles 224. Once more, with added reference to Fig. 1, the bubbles 225 are provided with a place to go at the circulation space 160. Thus, a circulation is provided with heat being carried away from the PCB 125 and to this space 160. Furthermore, to the extent that heated condensate of the liquid 101 has been brought to the circulation space 160, it may now cool and rejoin the remainder of the liquid 101 below which is removed from the location of the PCB 125.

With additional added reference to Fig. 1, in one embodiment, the circulation of the liquid 101 to the circulation space 160 may present an added opportunity for managing the production of particulate in the circulating liquid 101. So, for example, where there has been some degree of corrosion, abrasion or other deterioration of a PCB component, a collector located between the PCB 125 and the circulation space 160 may be employed. This may include a magnet to attract metal particulate or a mechanical filter to collect any form of minor debris. Thus, the circulating liquid 101 has now presented the opportunity to effectively reduce the presence of particulate that might otherwise effect PCB 125 performance.

The boiling point for the liquid 101 may be tailored to the sought after heat management applied to the PCB 125. For example, in one embodiment, the liquid 101 may be selected with a boiling point that is less than about 60°C to help ensure that PCB components do not sustain excessive heat for extended periods of time.

Continuing with reference to Fig. 2B, the side cross-sectional view reveals conventional PCB microchip components. These include interconnecting metal line traces 240 of copper or other suitable material. These are deposited within an etched dielectric 260 at a substrate 280. An electrode 275, otherwise prone to generate a hot spot at the PCB 125 is illustrated positioned at a barrier layer 290. Of course, any number of different PCB 125 architecture types may be employed which take advantage of effectively being bathed in the indicated shock-absorbing liquid 101.

Regardless of the specific architecture of the PCB 125, the degree of heat maintained at potential hot spots such as the noted electrode 275 is dramatically reduced by the surrounding presence of the shock-absorbing liquid 101. Once more, an overall electrical efficiency may be observed with a reduction in power consumption. The bathing presence of the liquid 101 may reduce the risk of electrical shorts and allow for reduced clearance and creepage distances. So, for example, just as the dielectric 260 isolates the metal line traces 240, so does the liquid 101 with respect to such features and others. That is, a new found manner of presenting the benefits of dielectric isolation is provided where the surrounding liquid 101 is itself a suitable dielectric.

Referring now to Fig. 3, a perspective overview of a subsea oilfield 301 is illustrated accommodating the SEM 100 of Fig. 1 within an SCM 305 at a secure location with subsea hardware. The SCM 305 may include the presence of insulation oil, platform connectors, retrieval architecture and a host of other features. Regardless, for the embodiment shown, the SCM 305 is located at a structural platform 315, well suited for securing the SEM 100 in position. However, the SCM 305 may be located at a variety of suitable hardware locations such as at manifold 350, 355 or any number of well Christmas trees 375, 377, 380, 390. Regardless of location, the SCM 305 may take advantage of the shock-absorbing and dielectric advantages afforded by the liquid 101 employed as described above (see Fig. 1).

In this particular layout, multiple well clusters 325, 335 are coupled to manifolds 350, 355. This oilfield 301 includes a conventional offshore platform 360 from which subsea operations, and indeed the SCM 305 itself, may be directed. In this particular example, bundled water and production lines 340 and bundled electrical/hydraulic lines 310 may run along the seabed between the platform 360 and the cluster locations.

The oilfield 301 accommodates the SCM 305 to help facilitate and promote production of fluids from the clusters 325, 335 of wells 375, 377, 380, 390 (see arrow 300). In spite of the potential for vibrations and mechanical disturbances throughout installation of the SCM 305 and subsequent production, the SCM 305 is particularly suited to avoid damage and maintain long term performance. Indeed, the SCM 305 is also resistant to shock that might be initiated by the SCM 305 itself. Further, where the shock resistant liquid 101 detailed above is tailored with proper dielectric properties, additional electrical component safeguarding may be provided to further extend the life of the SEM 100/SCM 305 (see Fig. 1).

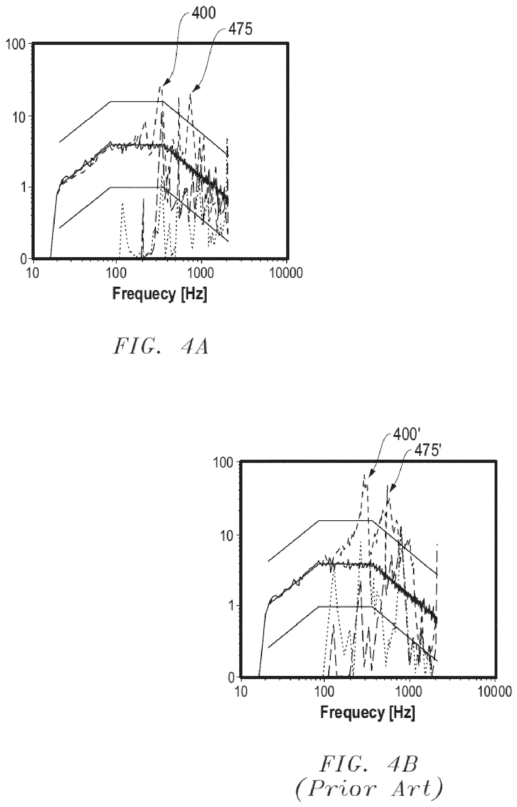

Referring now to Fig. 4A, a chart illustrating results of a random vibration test applied to the SEM 100 of Fig. 1 is shown. In this chart, the x-axis represents the frequency of vibrations in Hz applied to the SEM design, whereas the y-axis represents the resultant vibrations that resonate from the SEM in response thereto (again in Hz). This illustration is in contrast to the prior art chart of Fig. 4B which illustrates the same but without the use of shock absorbing fluid 101 included within the SEM 100 (see Fig. 1).

Looking at the two charts, it is evident that at about 280 Hz and again at about 520 Hz there are mechanical resonance peaks. Specifically, where 280 Hz is applied as noted along the x-axis, a peak 400 presents in Fig. 4A that is notably smaller than the same peak 400' in Fig. 4B. That is, where the shock-absorbing liquid is utilized, the peak is smaller by a factor of about 2.5. The same holds true where the 500 Hz is applied as noted along the x-axis. Specifically, where 500 Hz is applied, a peak 475 presents in Fig. 4A that is again notably smaller than the same peak 475' in Fig. 4B. Again, where the shock-absorbing liquid is utilized, the peak is smaller by a factor of about 2.5.

Of course, a variety of different observations may be made from such testing depending on the particular SEM 100 design and type of liquid utilized. Furthermore, results may vary depending on the level of vibration applied (e.g. along the x-axis). It may be that a more dramatic damping effect is observed where the vibration levels applied are at lower frequencies. However, it should remain that so long as the liquid is utilized, some degree of dampening should be observed. This may be beneficial in both SEM deployment as use as well as in the initial qualification process.

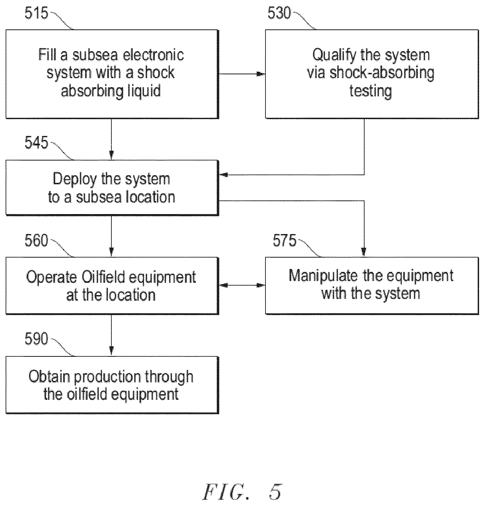

Referring now Fig. 5, a flow-chart summarizing an embodiment of employing a subsea electronic system in a subsea oilfield environment is shown. More specifically, an SEM utilizing a housing with shock absorbing liquid about electronic components is illustrated. As shown at 515, the SEM system is filled with a shock absorbing liquid and qualified for use (see 530). Of course, the use of the liquid is an aid to obtaining qualification. However, as a more practical matter, shock protection may be afforded to the system during deployment to the field as noted at 545. The same holds true for any number of potential shock inducing occurrences given the environment. That is, whether it be the operation of nearby oilfield equipment (560), the obtaining of production through such equipment (590) or even manipulation of the equipment with the very same SEM system (575), the potential for shock is ever present. Nevertheless, protection from the effects of such shock may be afforded to the SEM system, not to mention a host of other electronic efficiencies where the liquid is of a suitable dielectric variety as detailed above.

Embodiments described above provide electronic component architecture particularly configured for a subsea environment. Once more, the component architecture is rendered shock resistant in a manner that may reduce overall weight of structural hardware and may further enhance shock resistance and/or even minimize heat. So, for example, the life of electronic components, such as those of an SEM, may be substantially lengthened.

The preceding description has been presented with reference to presently preferred embodiments. Persons skilled in the art and technology to which these embodiments pertain will appreciate that alterations and changes in the described structures and methods of operation may be practiced without meaningfully departing from the principle and scope of these embodiments. For example, applications outside of the oilfield industry may benefit from teachings noted hereinabove. This may include subsea mining, subsea telecommunications, seabed positioned information technology server farms, subsea platforms for power distribution, converters and even offshore wind. Furthermore, the foregoing description should not be read as pertaining only to the precise structures described and shown in the accompanying drawings, but rather should be read as consistent with and as support for the following claims, which are to have their fullest and fairest scope.

## Claims

1. A subsea electronic assembly (100) for positioning in an environment of an oilfield and comprising:
a housing (190);
an electronic component (125, 127, 129) disposed within the housing to facilitate electrical coupling with a subsea device at the oilfield; and
a shock absorbing liquid (101) occupying space within the housing about the electronic component to enhance resistance to shock induced damage from the oilfield environment, wherein the shock absorbing liquid is a dielectric fluid including one of a fluorinated ketone and a fluorocarbon.

2. The subsea electronic assembly of claim 1, wherein the dielectric liquid enhances one of electrical efficiency, reliability and availability of the electronic component by reduction in one of a risk of electrical short, electrical clearance and creepage distance.

3. The subsea electronic assembly of claim 1, wherein the electronic component includes an absence of a conformal coating for one of added shock and added vibration resistance.

4. The subsea electronic assembly of claim 1, wherein the electronic component includes a heat generating feature and the shock absorbing liquid is a cooling liquid.

5. The subsea electronic assembly of claim 4, wherein the electronic component is absent heat sinks for one of added shock and added vibration resistance.

6. The subsea electronic assembly of claim 1, wherein the housing accommodates the electronic component, hardware and a remaining space, the remaining space including the shock-absorbing liquid and a circulation space to account for condensing of the shock-absorbing liquid.

7. The subsea electronic assembly of claim 6, wherein the circulation space accounts for less than about 25% of the remaining space.

8. The subsea electronic assembly of claim 1, wherein the assembly is configured to facilitate one of oilfield production management, subsea mining, subsea telecommunications, an information technology server farm at the seabed, power distribution from a subsea platform which includes a hardware at a seabed to secure the assembly thereat, a converter and offshore wind management.

9. The subsea electronic assembly of claim 8, wherein the assembly is configured to facilitate the oilfield production management and the hardware comprises one of a structural platform, a Christmas tree and a manifold.

10. The subsea electronic assembly of claim 9, wherein the assembly includes one of a subsea electronics module, an actuator, a subsea tool, a subsea sensor, an ROV, an AUV and communications equipment.

11. A method of managing operations at an oilfield, the method comprising:
deploying a subsea electronics assembly (100) according to any preceding claim to a seabed at the oilfield; and
manipulating equipment at the oilfield with aid of the module, the module including a housing (190) with an electronic component (125, 127, 129) bathed in a shock-absorbing liquid (101).

12. The method of claim 11 further comprising filling the housing of the module with the shock-absorbing liquid to a fill level above the electronic component.

13. The method of claim 12, further comprising boiling shock-absorbing liquid in contact with the electronic component toward a circulation space above the fill level to cool the component.

14. The method of claim 13, further comprising filtering a particulate out of the liquid between the component and the circulation space.

## Patentansprüche

1. Eine elektronische Unterwasseranordnung (100) zum Positionieren in einer Umgebung eines Ölfelds, umfassend:
ein Gehäuse (190);
ein elektronisches Bauteil (125, 127, 129), das innerhalb des Gehäuses angeordnet ist, um die elektrische Kopplung mit einer Unterwasservorrichtung am Ölfeld zu erleichtern, und
eine schockabsorbierende Flüssigkeit (101), die innerhalb des Gehäuses einen Raum um das elektronische Bauteil herum einnimmt, um den Widerstand gegen schockinduzierte Schäden aus der Umgebung des Ölfelds zu erhöhen, wobei die schockabsorbierende Flüssigkeit eine dielektrische Flüssigkeit ist, die eines von einem fluorierten Keton und einem Fluorkohlenwasserstoff enthält.

2. Die elektronische Unterwasseranordnung nach Anspruch 1, wobei die dielektrische Flüssigkeit eines von elektrischer Effizienz, Zuverlässigkeit und Verfügbarkeit des elektronischen Bauteils durch Verringern eines von einem elektrischem Kurzschlussrisiko, einem elektrischem Abstand und einer Kriechstrecke erhöht.

3. Die elektronische Unterwasseranordnung nach Anspruch 1, wobei das elektronische Bauteil sich durch die Abwesenheit von Schutzlack auszeichnet, um eines von zusätzlicher Schockfestigkeit und zusätzlicher Rüttelfestigkeit zu erhöhen.

4. Die elektronische Unterwasseranordnung nach Anspruch 1, wobei das elektronische Bauteil ein wärmeerzeugendes Merkmal enthält und die schockabsorbierende Flüssigkeit eine Kühlflüssigkeit ist.

5. Die elektronische Unterwasseranordnung nach Anspruch 4, wobei das elektronische Bauteil sich durch die Abwesenheit von Kühlkörpern auszeichnet, um eines von zusätzlicher Schockfestigkeit und zusätzlicher Rüttelfestigkeit zu erhöhen.

6. Die elektronische Unterwasseranordnung nach Anspruch 1, wobei das Gehäuse das elektronische Bauteil, Hardware und einen verbleibenden Raum beinhaltet, wobei der verbleibende Raum die schockabsorbierende Flüssigkeit und einen Zirkulationsraum für das Kondensieren der schockabsorbierenden Flüssigkeit enthält.

7. Die elektronische Unterwasseranordnung nach Anspruch 6, wobei der Zirkulationsraum weniger als ca. 25 % des verbleibenden Raums einnimmt.

8. Die elektronische Unterwasseranordnung nach Anspruch 1, wobei die Anordnung so konfiguriert ist, dass sie eines von Ölfeld-Produktionsmanagement, Unterwasser-Bergbau, Unterwasser-Telekommunikation, einen IT-Serverpark am Meeresboden, Stromverteilung aus einer Unterwasser-Plattform einschließlich Hardware zur Sicherung der Anordnung an einem Meeresboden, einem Umwandler und Offshore-Windnutzung erleichtert.

9. Die elektronische Unterwasseranordnung nach Anspruch 8, wobei die Anordnung so konfiguriert ist, dass sie das Ölfeld-Produktionsmanagement erleichtert und die Hardware eines von einer strukturellen Plattform, einem Eruptionskreuz und einem Verteiler umfasst.

10. Die elektronische Unterwasseranordnung nach Anspruch 9, wobei die Anordnung eines von einem Unterwasser-Elektronikmodul, einem Betätigungselement, einem Unterwasserwerkzeug, einem Unterwassersensor, einem ferngesteuerten Unterwasserfahrzeug (ROV), einem autonomen Unterwasserfahrzeug (AUV) und Kommunikationsgeräten enthält.

11. Ein Verfahren zum Betreiben eines Ölfelds, wobei das Verfahren Folgendes umfasst:
Anbringen einer elektronischen Unterwasseranordnung (100) nach einem der vorangehenden Ansprüche auf einem Meeresboden am Ölfeld; und
Bedienen von Geräten am Ölfeld mithilfe des Moduls, wobei das Modul ein Gehäuse mit einem elektronischen Bauteil (125, 127, 129) enthält, das in eine schockabsorbierende Flüssigkeit (101) eingetaucht ist.

12. Das Verfahren nach Anspruch 11, das ferner das Füllen des Modulgehäuses mit der schockabsorbierenden Flüssigkeit bis zu einem Füllstand oberhalb des elektronischen Bauteils umfasst.

13. Das Verfahren nach Anspruch 12, das ferner das Sieden von schockabsorbierender Flüssigkeit in Kontakt mit dem elektronischen Bauteil in Richtung eines Zirkulationsraums oberhalb des Füllstands zum Kühlen des Bauteils umfasst.

14. Das Verfahren nach Anspruch 13, das ferner das Filtern von Partikeln aus der Flüssigkeit zwischen dem Bauteil und dem Zirkulationsraum umfasst.

## Revendications

1. Ensemble électronique sous-marin (100) destiné à être positionné dans un environnement d'un champ pétrolifère et comprenant :
un boîtier (190) ;
un composant électronique (125, 217, 129) disposé à l'intérieur du boîtier facilite le couplage électrique avec un dispositif sous-marin sur le champ pétrolifère ; et
un liquide absorbant les chocs (101) occupant un espace à l'intérieur du boîtier autour du composant électronique pour améliorer la résistance aux dommages induits par les chocs provenant de l'environnement d'un champ pétrolifère, dans lequel le liquide absorbant les chocs est un fluide diélectrique comportant une cétone fluorée ou un fluorocarbone.

2. Ensemble électronique sous-marin selon la revendication 1, dans lequel le liquide diélectrique améliore l'un parmi l'efficacité électrique, la fiabilité et la disponibilité du composant électronique en réduisant un élément parmi un risque de court-circuit électrique, de gabarit électrification et de ligne de fuite.

3. Ensemble électronique sous-marin selon la revendication 1, dans lequel le composant électronique comporte une absence de revêtement conforme pour l'une parmi la résistance supplémentaire aux chocs et la résistance supplémentaire aux vibrations.

4. Ensemble électronique sous-marin selon la revendication 1, dans lequel le composant électronique comporte une caractéristique générant de la chaleur et le liquide absorbant les chocs est un liquide de refroidissement.

5. Ensemble électronique sous-marin selon la revendication 4, dans lequel le composant électronique est absent de dissipateurs de chaleur pour l'une parmi la résistance supplémentaire aux chocs et la résistance supplémentaire aux vibrations.

6. Ensemble électronique sous-marin selon la revendication 1, dans lequel le boîtier loge le composant électronique, le matériel et un espace restant, l'espace restant comportant le liquide absorbant les chocs et un espace de circulation pour tenir compte de la condensation du liquide absorbant les chocs.

7. Ensemble électronique sous-marin selon la revendication 6, dans lequel l'espace de circulation représente moins d'environ 25 % de l'espace restant.

8. Ensemble électronique sous-marin selon la revendication 1, dans lequel l'ensemble est conçu pour faciliter un élément parmi la gestion de la production de champ pétrolifère, l'exploitation minière sous-marine, les télécommunications sous-marines, une ferme de serveurs de technologie de l'information au fond marin, la distribution d'électricité à partir d'une plateforme sous-marine qui comporte un matériel à un fond marin pour y fixer solidement l'ensemble au niveau de celui-ci, un convertisseur et la gestion de l'éolien offshore.

9. Ensemble électronique sous-marin selon la revendication 8, dans lequel l'ensemble est conçu pour faciliter la gestion de la production de champ pétrolifère et le matériel comprend un parmi une plateforme structurale, un arbre de Noël et un collecteur.

10. Ensemble électronique sous-marin selon la revendication 9, dans lequel l'ensemble comporte un élément parmi un module électronique sous-marin, un actuateur, un outil sous-marin, un capteur sous-marin, un engin téléguidé (ROV), un drone sous-marin téléguidé (AUV) et un équipement de communication.

11. Procédé de gestion des mises en oeuvre sur un champ pétrolifère, le procédé comprenant :
le déploiement d'un ensemble électronique sous-marin (100) selon une quelconque revendication précédente à un fond marin sur le champ pétrolifère ; et
la manipulation de l'équipement sur le champ pétrolifère à l'aide du module, le module comportant un boîtier (190) avec un composant électronique (125, 127, 129) baigné dans un liquide absorbant les chocs (101).

12. Procédé selon la revendication 11, comprenant en outre le remplissage du boîtier du module avec le liquide absorbant les chocs jusqu'à un niveau de remplissage au-dessus du composant électronique.

13. Procédé selon la revendication 12, comprenant en outre l'ébullition d'un liquide absorbant les chocs en contact avec le composant électronique vers un espace de circulation au-dessus du niveau de remplissage pour refroidir le composant.

14. Procédé selon la revendication 13, comprenant en outre le filtrage d'une matière particulaire hors du liquide entre le composant et l'espace de circulation.
